# EUROPÄISCHE PATENTSCHRIFT

(11) **EP 2 368 278 B1**
(45) Veröffentlichungstag und Bekanntmachung des Hinweises auf die Patenterteilung: **12.03.2014**
(21) Anmeldenummer: 09796292.2
(22) Anmeldetag: 02.11.2009
(51) Int. Cl.: H01L 33/22

(54) **OPTOELEKTRONISCHER HALBLEITERCHIP UND VERFAHREN ZUR HERSTELLUNG EINES OPTOELEKTRONISCHEN HALBLEITERCHIPS**
OPTOELECTRONIC SEMICONDUCTOR CHIP AND METHOD FOR PRODUCING AN OPTOELECTRONIC SEMICONDUCTOR CHIP
PUCE DE SEMICONDUCTEUR OPTOÉLECTRONIQUE ET PROCÉDÉ DE FABRICATION D'UNE PUCE DE SEMICONDUCTEUR OPTOÉLECTRONIQUE

(30) Priorität: 23.12.2008 DE 102008062932
(43) Veröffentlichungstag der Anmeldung: 28.09.2011
(73) Patentinhaber: OSRAM Opto Semiconductors GmbH, 93055 Regensburg (DE)
(72) Erfinder: GMEINWIESER, Nikolaus, 93083 Obertraubling (DE); SABATHIL, Matthias, 93059 Regensburg (DE); LEBER, Andreas, 93049 Regensburg (DE)
(74) Vertreter: Epping - Hermann - Fischer
(86) Internationale Anmeldenummer: PCT/DE2009/001550
(87) Internationale Veröffentlichungsnummer: WO 2010/072187

(56) Entgegenhaltungen:
- WO-A1-2005/041313
- DE-A1- 10 234 977
- DE-A1- 10 313 606
- DE-A1-102006 017 573
- JP-A- 2007 220 972
- US-A1- 2007 262 300
- US-A1- 2007 269 918

## Beschreibung

Es wird ein optoelektronischer Halbleiterchip angegeben. Darüber hinaus wird ein Verfahren zur Herstellung eines optoelektronischen Halbleiterchips angegeben.

Die Druckschrift US 2007/0267640 A1 betrifft eine lichtemittierende Halbleiterdiode und eine Herstellungsmethode für eine solche.

In der Druckschrift JP 2007-220 972 A ist ein Licht emittierendes Halbleiterbauteil angegeben.

Ein Licht emittierendes Nitrid-Halbleiterbauteil findet sich in der Druckschrift US 2007/0269918 A1.

Eine zu lösende Aufgabe besteht darin, einen optoelektronischen Halbleiterchip anzugeben, der eine hohe Lichtauskoppeleffizienz aufzeigt. Eine weitere zu lösende Aufgabe besteht darin, ein Herstellungsverfahren für einen optoelektronischen Halbleiterchip anzugeben.

Gemäß zumindest einer Ausführungsform des optoelektronischen Halbleiterchips umfasst dieser eine Halbleiterschichtenfolge mit mindestens einer aktiven Schicht zur Erzeugung einer elektromagnetischen Strahlung. Die aktive Schicht kann zumindest einen pn-Übergang und/oder zumindest einen Quantentrog aufweisen. Zum Beispiel kann der Halbleiterchip als Dünnfilmchip ausgeformt sein, wie in der Druckschrift WO 2005/081319 A1 beschrieben. Weiterhin kann die Halbleiterschichtenfolge Mantelschichten, Wellenleiterschichten und/oder Stromaufweitungsschichten aufweisen.

Gemäß zumindest einer Ausführungsform des optoelektronischen Halbleiterchips basiert die gesamte Halbleiterschichtenfolge auf demselben Materialsystem, wobei einzelne Schichten der Halbleiterschichtenfolge eine unterschiedliche Materialzusammensetzung, etwa eine unterschiedliche Dotierung, aufweisen können. Beispielsweise basiert die Halbleiterschichtenfolge auf GaN, GaP oder GaAs, wobei insbesondere ein Anteil etwa von A1 und/oder In innerhalb der Schichtenfolge variieren kann. Ebenso kann die Halbleiterschichtenfolge variierende Anteile von P, B, Mg und/oder Zn beinhalten.

Gemäß zumindest einer Ausführungsform des optoelektronischen Halbleiterchips weist dieser Auskoppelstrukturen auf, die dazu eingerichtet sind, eine Auskoppeleffizienz von in der aktiven Schicht im Betrieb des Halbleiterchips erzeugter Strahlung aus dem Halbleiterchip heraus zu erhöhen.

Gemäß zumindest einer Ausführungsform des optoelektronischen Halbleiterchips weisen die Auskoppelstrukturen Facetten auf. Facetten sind hierbei alle Begrenzungsflächen der Auskoppelstrukturen oder Teile solcher Begrenzungsflächen, die nicht der Halbleiterschichtenfolge abgewandt sind und die mit einer Strahlungsdurchtrittsfläche der Halbleiterschichtenfolge einen Winkel zwischen einschließlich 15° und 75° bilden. Die Facette einer Auskoppelstruktur kann durch eine einzige, zusammenhängende Fläche gebildet sein. Sind die Auskoppelstrukturen beispielsweise Kegelstümpfe, so sind die Facetten durch laterale Mantelflächen der Kegelstümpfe gebildet. Sind die Auskoppelstrukturen zum Beispiel halbkugelartig, so sind die Facetten dann nur diejenigen Teile der Begrenzungsflächen, deren Tangenten einen Winkel zwischen einschließlich 15° und 75° mit der Strahlungsdurchtrittsfläche einschließen, wobei die Tangenten jeweils in Ebenen senkrecht zur Strahlungsdurchtrittsfläche liegen.

Die Strahlungsdurchtrittsfläche des optoelektronischen Halbleiterchips ist hierbei bevorzugt diejenige, im Rahmen der Herstellungstoleranzen insbesondere ebene Fläche, die senkrecht zu einer Wachstumsrichtung der Halbleiterschichtenfolge orientiert ist und diese in einer Richtung senkrecht zur Wachstumsrichtung begrenzt. Das heißt, die Strahlungsdurchtrittsfläche ist eine Hauptseite der Halbleiterschichtenfolge. Insbesondere befindet sich die Strahlungsdurchtrittsfläche an einer einem Träger oder Substrat abgewandten Seite der Halbleiterschichtenfolge. Die Strahlungsdurchtrittsfläche ist dazu eingerichtet, dass zumindest ein Teil der in der Halbleiterschichtenfolge erzeugten Strahlung die Halbleiterschichtenfolge durch die Strahlungsdurchtrittsfläche verlässt.

Die Auskoppelstrukturen sind unmittelbar auf der Strahlungsdurchtrittsfläche angebracht. Mit anderen Worten steht ein Material der Auskoppelstrukturen mindestens stellenweise in direktem Kontakt mit der Strahlungsdurchtrittsfläche beziehungsweise mit dem Halbleitermaterial der Halbleiterschichtenfolge, mit dem die Strahlungsdurchtrittsfläche gebildet ist.

Gemäß zumindest einer Ausführungsform des optoelektronischen Halbleiterchips ist das Material der Auskoppelstrukturen von dem Material der Halbleiterschichtenfolge verschieden. Verschieden bedeutet hierbei, dass die Auskoppelstrukturen auf einem anderen Materialsystem beruhen als die Halbleiterschichtenfolge. Es ist also insbesondere nicht gemeint, dass sich die Materialien von Auskoppelstrukturen und Halbleiterschichtenfolge lediglich in einer Dotierung oder in einem Anteil einer Materialkomponente unterscheiden. Zum Beispiel basiert die Halbleiterschichtenfolge auf GaN, während die Auskoppelstrukturen auf TiO₂ basieren.

Gemäß zumindest einer Ausführungsform des optoelektronischen Halbleiterchips weichen die Brechungsindices der Materialien der Auskoppelstrukturen und der Halbleiterschichtenfolge um höchstens 30 % voneinander ab. Mit anderen Worten ist der Betrag des Quotienten aus der Differenz der Brechungsindices beider Materialien und dem Brechungsindex des Materials der Halbleiterschichtenfolge kleiner oder gleich 0,30. Unter dem Material der Halbleiterschichtenfolge ist hierbei insbesondere dasjenige Material der Halbleiterschichtenfolge zu verstehen, durch das die Strahlungsdurchtrittsfläche gebildet ist. Die Auskoppelstrukturen und die Halbleiterschichtenfolge können also einen voneinander verschiedenen Brechungsindex aufweisen.

Unter Brechungsindex ist hierbei insbesondere jeweils der Brechungsindex bei einer relevanten Wellenlänge oder in einem relevanten Wellenlängenbereich zu verstehen. Die relevante Wellenlänge ist insbesondere eine Wellenlänge der in der Halbleiterschichtenfolge erzeugten Strahlung.

Gemäß zumindest einer Ausführungsform des optoelektronischen Halbleiterchips beträgt eine Gesamtfläche der Facetten der Auskoppelstrukturen mindestens 5 %, bevorzugt mindestens 20 %, insbesondere mindestens 60 % eines Flächeninhalts der Strahlungsdurchtrittsfläche. Mit anderen Worten entspricht die Summe aus den Flächen aller Facetten, also aller Begrenzungsflächen der Auskoppelstrukturen, die schräg zur Strahlungsdurchtrittsfläche angeordnet sind, mindestens den oben genannten Werten. Das heißt, es ist also die Gesamtfläche der Facetten mit dem Flächeninhalt der Strahlungsdurchtrittsfläche in Relation gesetzt.

Es ist in zumindest einer Ausführungsform auch möglich, dass die Gesamtfläche der Facetten größer ist als der Flächeninhalt der Strahlungsdurchtrittsfläche. In diesem Fall betragen die Flächen der Facetten mehr als 100 % des Flächeninhalts der Strahlungsdurchtrittsfläche.

In mindestens einer Ausführungsform des optoelektronischen Halbleiterchips umfasst dieser eine Halbleiterschichtenfolge mit mindestens einer aktiven Schicht, die zur Erzeugung einer elektromagnetischen Strahlung eingerichtet ist. Weiterhin weist der optoelektronische Halbleiterchip Auskoppelstrukturen auf, die mindestens mittelbar auf einer Strahlungsdurchtrittsfläche der Halbleiterschichtenfolge angebracht sind. Ein Material der Auskoppelstrukturen ist hierbei von einem Material der Halbleiterschichtenfolge verschieden. Die Brechungsindices der Materialien der Auskoppelstrukturen und der Halbleiterschichtenfolge weichen um höchstens 30 % voneinander ab. Des Weiteren weisen Facetten der Auskoppelstrukturen eine Gesamtfläche auf, die mindestens 5 % eines Flächeninhalts der Strahlungsdurchtrittsfläche beträgt.

Über derartige Auskoppelstrukturen, die insbesondere einen geringen Brechungsindexunterschied zum Material der Halbleiterschichtenfolge aufweisen, ist eine hohe Auskoppeleffizienz der im Halbleiterchip erzeugten Strahlung aus diesem heraus gewährleistbar. Da die Auskoppelstrukturen mit einem anderen Material gestaltet sind als die Halbleiterschichtenfolge, kann sich zudem die Herstellung der Auskoppelstrukturen und somit auch des optoelektronischen Halbleiterchips vereinfachen.

Gemäß zumindest einer Ausführungsform des optoelektronischen Halbleiterchips bedecken die Auskoppelstrukturen einen Anteil der Strahlungsdurchtrittsfläche von mindestens 20 %, insbesondere von mindestens 40 %. Stehen die Auskoppelstrukturen in unmittelbarem Kontakt zur Strahlungsdurchtrittsfläche, so beträgt derjenige Anteil der Strahlungsdurchtrittsfläche, der mit dem Material der Auskoppelstrukturen in direktem Kontakt steht, mindestens 20 % beziehungsweise mindestens 40 %.

Gemäß zumindest einer Ausführungsform des optoelektronischen Halbleiterchips bedecken die Auskoppelstrukturen einen Anteil der Strahlungsdurchtrittsfläche von höchstens 80 %.

Gemäß zumindest einer Ausführungsform des optoelektronischen Halbleiterchips weichen die Brechungsindices der Materialien der Auskoppelstrukturen und der Halbleiterschichtenfolge um höchstens 20 %, insbesondere um höchstens 10 % voneinander ab. Beträgt die Abweichung zum Beispiel höchstens 10 % und weist ein Brechungsindex der Halbleiterschichtenfolge einen Wert von zirka 2,5 auf, so beträgt der Brechungsindex des Materials der Auskoppelstrukturen zwischen einschließlich 2,25 und 2,75.

Gemäß zumindest einer Ausführungsform des optoelektronischen Halbleiterchips weichen die Brechungsindices der Materialien der Auskoppelstrukturen und der Halbleiterschichtenfolge um höchstens 5 % voneinander ab.

Gemäß zumindest einer Ausführungsform des optoelektronischen Halbleiterchips ist der durch die Auskoppelstrukturen bedeckte Anteil der Strahlungsdurchtrittsfläche größer als 35 % und kleiner als 65 %.

Gemäß zumindest einer Ausführungsform des optoelektronischen Halbleiterchips sind die Auskoppelstrukturen in einem regelmäßigen, insbesondere zweidimensionalen Muster auf der Strahlungsdurchtrittsfläche angeordnet. Regelmäßig kann hierbei bedeuten, dass das Muster eine Einheitszelle aufweist. Eine regelmäßige Anordnung der Auskoppelstrukturen ist zum Beispiel über einen fotolithographischen Prozess realisierbar.

Gemäß zumindest einer Ausführungsform des optoelektronischen Halbleiterchips sind die Auskoppelstrukturen auf der Strahlungsdurchtrittsfläche in einem hexagonalen Gitter angeordnet. Mit anderen Worten ist eine Einheitszelle der Anordnung der Auskoppelstrukturen ein Sechseck, insbesondere ein regelmäßiges und/oder gleichseitiges Sechseck.

Gemäß zumindest einer Ausführungsform des optoelektronischen Halbleiterchips weisen die Auskoppelstrukturen eine laterale Ausdehnung, also in einer Richtung parallel zur Strahlungsdurchtrittsfläche, auf, die zwischen einschließlich 0,2 µm und 10 µm liegt, insbesondere zwischen einschließlich 1 µm und 3 µm. Bevorzugt ist die laterale Ausdehnung der Auskoppelstrukturen größer als eine Wellenlänge der in der Halbleiterschichtenfolge erzeugten Strahlung. Insbesondere entspricht die laterale Ausdehnung der Auskoppelstrukturen mindestens dem Doppelten der Wellenlänge der Strahlung. Die Wellenlänge bezeichnet hierbei die Wellenlänge der Strahlung im Material der Halbleiterschichtenfolge.

Gemäß zumindest einer Ausführungsform des optoelektronischen Halbleiterchips sind durch das Material der Auskoppelstrukturen Inseln gebildet, wobei benachbarte Inseln voneinander separiert sind. Mit anderen Worten berühren sich benachbarte Inseln der Auskoppelstrukturen nicht. Es besteht zwischen benachbarten Auskoppelstrukturen oder Inseln also keine Verbindung durch das Material der Auskoppelstrukturen selbst. Die Inseln sind jeweils insbesondere durch genau ein Strukturelement der Auskoppelstrukturen gebildet. Beispielsweise sind Inseln dann kegelstumpfartig geformt.

Gemäß zumindest einer Ausführungsform des optoelektronischen Halbleiterchips ist ein Abstand zwischen benachbarten Auskoppelstrukturen oder Inseln mindestens so groß wie die Vakuumwellenlänge der in der Halbleiterschichtenfolge erzeugten Strahlung. Hierdurch können zum Beispiel Effekte ähnlich wie bei einem Beugungsgitter gemindert werden.

Gemäß zumindest einer Ausführungsform des optoelektronischen Halbleiterchips sind die Auskoppelstrukturen kugelsegmentartig, kuppelartig, pyramidenartig und/oder kegelstumpfartig gestaltet, wobei eine Basisfläche der Auskoppelstrukturen der Strahlungsdurchtrittsfläche zugewandt ist. Die Basisfläche entspricht hierbei zum Beispiel der Grundfläche einer Kuppel, eines Pyramidenstumpfes oder eines Kegelstumpfes. Der Winkel zwischen den Facetten dieser Auskoppelstrukturen und der Strahlungsdurchtrittsfläche beträgt zum Beispiel zirka 45°.

Kuppelartig bedeutet hierbei, dass eine der Strahlungsdurchtrittsfläche abgewandte, insbesondere einzige Begrenzungsfläche einer massiven Auskoppelstruktur gekrümmt oder rund ist. Die Facetten der Auskoppelstrukturen sind dann nur die Teile dieser Begrenzungsflächen, die einen Winkel zwischen einschließlich 15° und 75° zur Strahlungsdurchtrittsfläche aufweisen.

Gemäß zumindest einer Ausführungsform des optoelektronischen Halbleiterchips weisen die Auskoppelstrukturen eine Höhe auf, in einer Richtung senkrecht zur Strahlungsdurchtrittsfläche, die zwischen einschließlich 0,3 µm und 10 µm liegt, insbesondere zwischen einschließlich 0,5 µm und 3 µm.

Gemäß zumindest einer Ausführungsform des optoelektronischen Halbleiterchips ist die laterale Ausdehnung der Halbleiterchips gleich oder näherungsweise gleich der Höhe der Auskoppelstrukturen. Näherungsweise gleich kann bedeuten, dass die Höhe und die laterale Ausdehnung um weniger als 25 %, insbesondere um weniger als 10 % voneinander abweichen.

Gemäß zumindest einer Ausführungsform des optoelektronischen Halbleiterchips ist die gesamte Strahlungsdurchtrittsfläche, im Rahmen der Herstellungstoleranzen, gleichmäßig von den Auskoppelstrukturen bedeckt. Das heißt, ein Anordnungsmuster der Auskoppelstrukturen auf der gesamten Strahlungsdurchtrittsfläche variiert, im Rahmen der Herstellungstoleranzen, nicht.

Gemäß zumindest einer Ausführungsform des optoelektronischen Halbleiterchips sind die Auskoppelstrukturen kugelsegmentartig geformt. Kugelsegmentartig schließt hierbei nicht aus, dass die Auskoppelstrukturen die Form eines Segments eines Ellipsoids aufweisen können.

Gemäß zumindest einer Ausführungsform des optoelektronischen Halbleiterchips ist das Material der Auskoppelstrukturen transparent für die in der Halbleiterschichtenfolge erzeugte Strahlung. Mit anderen Worten werden weniger als 20 %, insbesondere weniger als 5 % der die Auskoppelstrukturen durchlaufenden, in der Halbleiterschichtenfolge erzeugten Strahlung durch das Material der Auskoppelstrukturen absorbiert. Die Auskoppelstrukturen sind also bezüglich der erzeugten Strahlung klarsichtig gestaltet.

Gemäß zumindest einer Ausführungsform des optoelektronischen Halbleiterchips wirkt das Material der Auskoppelstrukturen streuend für die in der Halbleiterschichtenfolge erzeugte Strahlung. Bevorzugt absorbiert das Material weniger als 20 %, insbesondere weniger als 5 % der die Auskoppelstrukturen durchlaufenden, in der Halbleiterschichtenfolge erzeugten Strahlung.

Gemäß zumindest einer Ausführungsform des optoelektronischen Halbleiterchips weisen die Auskoppelstrukturen zumindest einen schichtartigen, durchgehenden Bereich auf, in dem eine Mehrzahl von Öffnungen gebildet ist. Die Öffnungen durchdringen den schichtartigen Bereich vollständig, in einer Richtung hin zur Strahlungsdurchtrittsfläche. Die Öffnungen reichen mindestens bis hin zur Strahlungsdurchtrittsfläche der Halbleiterschichtenfolge. Bevorzugt dringen die Öffnungen nicht oder nicht signifikant in die Halbleiterschichtenfolge ein. Die Facetten der Auskoppelstrukturen sind mindestens zum Teil durch die Öffnungen gebildet. Mit anderen Worten ist an mindestens einem Teilbereich der Strahlungsdurchtrittsfläche eine Schicht aus dem Material der Auskoppelstrukturen geformt, und in diese Schicht werden die Öffnungen, Durchbrüche, Ausnehmungen oder Löcher geformt. Durch diese Öffnungen sind laterale Grenzflächen in dieser Schicht gebildet, wobei diese Grenzflächen, mindestens zum Teil, Facetten der Auskoppelstrukturen darstellen. Bevorzugt verjüngen sich die Öffnungen zur Strahlungsdurchtrittsfläche hin. Beispielsweise weisen die Öffnungen eine kegelstumpfähnliche oder pyramidenstumpfähnliche Form auf, wobei eine schmalere Basisseite der Strahlungsdurchtrittsfläche zugewandt ist.

Gemäß zumindest einer Ausführungsform des optoelektronischen Halbleiterchips sind die Auskoppelstrukturen mit einem dielektrischen Material gebildet. Dielektrisch kann insbesondere auch bedeuten, dass eine spezifische elektrische Leitfähigkeit des Materials der Auskoppelstrukturen mindestens um einen Faktor 10, bevorzugt mindestens um einen Faktor 100 kleiner ist als eine spezifische elektrische Leitfähigkeit des die Strahlungsdurchtrittsfläche bildende Material der Halbleiterschichtenfolge. Dielektrisch schließt hierbei also nicht notwendig aus, dass das Material der Auskoppelstrukturen halbleitende Eigenschaften mit einer geringen spezifischen elektrischen Leitfähigkeit aufweist.

Gemäß zumindest einer Ausführungsform des optoelektronischen Halbleiterchips ist das Material der Auskoppelstrukturen elektrisch leitend. Bevorzugt übersteigt dann die elektrische Leitfähigkeit des Materials der Auskoppelstrukturen diejenige des Materials der Halbleiterschichtenfolge.

Gemäß zumindest einer Ausführungsform des optoelektronischen Halbleiterchips weist das Material der Auskoppelstrukturen einen der folgenden Stoffe auf oder besteht aus einem dieser Stoffe: TiO₂, ZnS, AlN, SiC, BN, Ta₂O_{5.}

Gemäß zumindest einer Ausführungsform des optoelektronischen Halbleiterchips beträgt der Brechungsindex des Materials der Auskoppelstrukturen mindestens 2,1, bevorzugt mindestens 2,25, insbesondere mindestens 2,4.

Gemäß zumindest einer Ausführungsform des optoelektronischen Halbleiterchips ist auf der Strahlungsdurchtrittsfläche der Halbleiterschichtenfolge stellenweise mindestens eine leitende Schicht aufgebracht, wobei die leitende Schicht insbesondere aus einem transparenten, leitfähigen Oxid gestaltet ist. Die leitende Schicht ist dazu eingerichtet, eine hohe elektrische Querleitfähigkeit aufzuweisen. Über die leitende Schicht kann also eine gleichmäßige Stromeinprägung in die Halbleiterschichtenfolge über die gesamte Strahlungsdurchtrittsfläche hinweg realisiert sein. Zum Beispiel ist die leitende Schicht mit Indiumzinnoxid, kurz ITO, mit Indiumzinkoxid, kurz IZO, oder mit ZnO gestaltet oder besteht aus einem dieser Materialien.

Gemäß zumindest einer Ausführungsform des optoelektronischen Halbleiterchips ist die leitende Schicht von den Auskoppelstrukturen vollständig durchdrungen. Beispielsweise sind in die leitende Schicht Löcher eingebracht, etwa mittels Ätzen, in die die Auskoppelstrukturen aufgebracht oder aufgewachsen werden. Das Material der Auskoppelstrukturen steht hierbei in direktem Kontakt zum Material der Strahlungsdurchtrittsfläche. Dadurch, dass die Auskoppelstrukturen die leitende Schicht durchdringen, ist eine hohe Auskoppeleffizienz gewährleistet. Dies gilt insbesondere, da der Brechungsindex von zum Beispiel transparenten leitfähigen Oxiden mit Werten von um 2,0 im Vergleich beispielsweise zu GaN, Brechungsindex zirka 2,5, relativ klein ist.

Gemäß zumindest einer Ausführungsform des optoelektronischen Halbleiterchips ist die Strahlungsdurchtrittsfläche, auf der die Auskoppelstrukturen aufgebracht sind, mit n-leitendem Material gebildet.

Gemäß zumindest einer Ausführungsform des optoelektronischen Halbleiterchips ist die Strahlungsdurchtrittsfläche, im Rahmen der Herstellungstoleranzen, eben gestaltet.

Gemäß zumindest einer Ausführungsform des optoelektronischen Halbleiterchips erheben sich die Auskoppelstrukturen, in einer Richtung von der Halbleiterschichtenfolge weg, über das Material der Halbleiterschichtenfolge. Mit anderen Worten sind die Auskoppelstrukturen nicht durch Materialwegnahme oder Vertiefungen in der Halbleiterschichtenfolge gebildet, sondern nach Fertigstellung der Halbleiterschichtenfolge auf dieser aufgebracht und/oder aufgewachsen.

Gemäß zumindest einer Ausführungsform des optoelektronischen Halbleiterchips liegt eine Wellenlänge der in der Halbleiterschichtenfolge erzeugten Strahlung im ultravioletten, im sichtbaren und/oder im nahinfraroten Spektralbereich. Die Strahlung weist also eine Wellenlänge zwischen einschließlich 200 nm und 1500 nm, insbesondere zwischen einschließlich 340 nm und 1080 nm, auf.

Gemäß zumindest einer Ausführungsform des optoelektronischen Halbleiterchips ist eine Wellenlänge der in der Halbleiterschichtenfolge erzeugten Strahlung insbesondere kleiner oder gleich 600 nm. Die Strahlung ist also insbesondere ultraviolette Strahlung oder durch blaues oder grünes Licht gebildet.

Gemäß zumindest einer Ausführungsform des optoelektronischen Halbleiterchips liegt der Winkel zwischen den Flanken und der Strahlungsdurchtrittsfläche zwischen einschließlich 40° und 50°.

Gemäß zumindest einer Ausführungsform des optoelektronischen Halbleiterchips ist das Material der Halbleiterschichtenfolge mit GaN, InGaN, AlGaN und/oder AlInGaN gebildet. Eine Wellenlänge der Strahlung ist insbesondere kleiner oder gleich 600 nm. Der Winkel zwischen den Facetten und der Strahlungsdurchtrittsfläche beträgt zwischen einschließlich 30° und 60°. Zudem sind die Auskoppelstrukturen kegelstumpfartig geformt und bestehen aus TiO₂.

Gemäß zumindest einer Ausführungsform des optoelektronischen Halbleiterchips ist die Funktionsweise oder Wirkungsweise der Auskoppelstrukturen näherungsweise mittels geometrischer Optik beschreibbar. Die Auskoppelstrukturen bilden also insbesondere keinen, auf Wellenoptik basierenden photonischen Kristall. Eine typische Längenskala oder Periodizität der Auskoppelstrukturen entspricht also mindestens einer Wellenlänge der aus der Halbleiterschichtenfolge auszukoppelnden Strahlung.

Gemäß zumindest einer Ausführungsform des optoelektronischen Halbleiterchips weisen die Hauptseiten der Halbleiterschichtenfolge keine Strukturierung oder Aufrauung auf. Mit anderen Worten sind die Hauptseiten der Halbleiterschichtenfolge glatt. Die leitende Schicht ist bevorzugt auch glatt und nicht aufgeraut.

Darüber hinaus wird ein Verfahren zur Herstellung eines optoelektronischen Halbleiterchips angegeben. Mit dem Verfahren kann beispielsweise ein optoelektronischer Halbleiterchip hergestellt werden, wie er in Verbindung mit zumindest einer der beschriebenen Ausführungsformen angegeben ist.

Gemäß zumindest einer Ausführungsform des Verfahrens wird eine Halbleiterschichtenfolge mit mindestens einer aktiven Schicht auf einem Substrat aufgewachsen. Bei dem Aufwachsen kann es sich um ein epitaktisches Aufwachsen handeln. Das Substrat ist insbesondere ein Aufwachssubstrat.

Gemäß zumindest einer Ausführungsform des Verfahrens wird auf eine Strahlungsdurchtrittsfläche der Halbleiterschichtenfolge ein lichtempfindliches Material aufgebracht und strukturiert. Bei dem lichtempfindlichen Material handelt es sich zum Beispiel um einen Fotolack oder um ein anderes Material, das über Strahlung strukturierbar ist. Strahlung kann hierbei auch UV-Strahlung, Röntgenstrahlung, Elektronenstrahlung oder Ionenstrahlung bedeuten.

Das Strukturieren ist beispielsweise ein Belichten mittels einer Fotomaske und gegebenenfalls nachfolgendes Entwickeln des lichtempfindlichen Materials. Mit anderen Worten besteht das Strukturieren im Ausbilden insbesondere fototechnisch ausgehärteter Bereiche des lichtempfindlichen Materials. In diesem Kontext bedeutet Strukturieren also keine signifikante Wegnahme von lichtempfindlichem Material.

Gemäß zumindest einer Ausführungsform des Verfahrens wird das lichtempfindliche Material in Teilbereichen entfernt. Bei dem Entfernen kann es sich um ein Ätzen oder ein Veraschen handeln. Beispielsweise werden unbelichtete oder alternativ belichtete Bereiche des lichtempfindlichen Materials verascht, nasschemisch oder mittels eines Plasmas weggeätzt und/oder mittels eines Lösungsmittels weggewaschen oder aufgelöst.

Gemäß zumindest einer Ausführungsform des Verfahrens wird anstelle des lichtempfindliche Materials eine Maske zum Beispiel mittels eines Stempelverfahrens oder eines Druckverfahrens an der Strahlungsdurchtrittsfläche der Halbleiterschichtenfolge aufgebracht. Es kann auch ein sogenanntes Imprint-Verfahren eingesetzt werden, bei dem ein die Maske bildendes Material in einer insbesondere homogenen Schicht aufgebracht wird, wobei nachfolgend in dieser Schicht dann mittels zum Beispiel eines Stempels Öffnungen erzeugt werden, bevor ein Aushärten des Materials erfolgt. Die Auskoppelstrukturen werden dann in diesen Öffnungen gebildet.

Gemäß zumindest einer Ausführungsform des Verfahrens wird das die Auskoppelstrukturen bildende Material in einer im Rahmen der Herstellungstoleranzen insbesondere homogenen Schicht an der Strahlungsdurchtrittsfläche der Halbleiterschichtenfolge aufgebracht. Anschließend erfolgt eine Gestaltung dieser Schicht zu den Auskoppelstrukturen, zum Beispiel über einen photolithographischen Prozess und/oder über ein nasschemisches oder trockenchemisches Ätzen.

Gemäß zumindest einer Ausführungsform des Verfahrens werden Auskoppelstrukturen, die sich mindestens mittelbar an der Strahlungsdurchtrittsfläche befinden, in den Teilbereichen erstellt. Bei dem Erstellen der Auskoppelstrukturen kann es sich um ein Aufwachsen und/oder ein Aufdampfen handeln. Auch ist es möglich, dass das Erstellen der Auskoppelstrukturen über einen selbstorganisierenden Prozess erfolgt.

Gemäß zumindest einer Ausführungsform des Verfahrens wird insbesondere nach dem Erstellen der Auskoppelstrukturen das restliche lichtempfindliche Material entfernt. Das Entfernen ist beispielsweise durch ein Abblasen realisierbar. Mit diesem Entfernen des restlichen lichtempfindlichen Materials kann auch ein auf dem lichtempfindlichen Material abgeschiedenes Restmaterial des die Auskoppelstrukturen bildenden Materials entfernt werden.

In mindestens einer Ausführungsform des Verfahrens zur Herstellung eines optoelektronischen Halbleiterchips umfasst dieses die Schritte:
- Wachsen einer Halbleiterschichtenfolge mit mindestens einer aktiven Schicht auf einem Substrat,
- Aufbringen und Strukturieren eines lichtempfindlichen Materials an einer Strahlungsdurchtrittsfläche der Halbleiterschichtenfolge,
- Entfernen des lichtempfindlichen Materials in Teilbereichen,
- Erstellen von Auskoppelstrukturen mindestens mittelbar an der Strahlungsdurchtrittsfläche in den Teilbereichen, und
- Entfernen des restlichen lichtempfindlichen Materials.

Bevorzugt erfolgt die Reihenfolge der Verfahrensschritte wie angegeben. Eine abweichende Reihenfolge kann allerdings, abhängig von einer konkreten Ausgestaltung des herzustellenden, optoelektronischen Halbleiterchips, ebenfalls Anwendung finden.

Gemäß zumindest einer Ausführungsform des Verfahrens wird vor dem Aufbringen und Strukturieren des lichtempfindlichen Materials zwischen dem lichtempfindlichen Material und der Strahlungsdurchtrittsfläche der Halbleiterschichtenfolge zumindest stellenweise eine leitende Schicht erzeugt.

Gemäß zumindest einer Ausführungsform des Verfahrens wird mit dem Entfernen des lichtempfindlichen Materials in den Teilbereichen ebenfalls die leitende Schicht in diesen Teilbereichen entfernt. Mit anderen Worten erfolgt ein Abtragen von Material der leitenden Schicht und von lichtempfindlichem Material im selben Verfahrensschritt, insbesondere im selben Ätzschritt. Zum Erzeugen eines Musters oder einer Struktur der leitenden Schicht und zum Erstellen der Auskoppelstrukturen wird also dieselbe Maske, in Gestalt des lichtempfindlichen Materials, verwendet.

Gemäß zumindest einer Ausführungsform des Verfahrens beinhaltet dieses den Schritt des Umbondens der gewachsenen Halbleiterschichtenfolge auf einen Träger. Bei dem Träger handelt es sich also insbesondere um kein Aufwachssubstrat. Der Träger ist dazu eingerichtet, die Halbleiterschichtenfolge mechanisch zu tragen und zu stützen. Bevorzugt erfolgt das Umbonden auf den Träger vor dem Schritt des Aufbringens und Strukturierens des lichtempfindlichen Materials.

Das Verfahren kann weitere Schritte beinhalten. Beispielsweise können elektrische Kontakte erstellt werden, eine im Waferbund gewachsene Halbleiterschichtenfolge kann in eine Vielzahl separater Halbleiterchips aufgeteilt werden und/oder es kann eine Vergussmasse, beispielsweise ein Silikon oder ein Epoxid, über der Halbleiterschichtenfolge und/oder den Auskoppelstrukturen aufgebracht werden.

Einige Anwendungsbereiche, in denen hier beschriebene optoelektronische Halbleiterchips Verwendung finden können, sind etwa die Hinterleuchtungen von Displays oder Anzeigeeinrichtungen. Weiterhin können die hier beschriebenen Halbleiterchips auch in Beleuchtungseinrichtungen zu Projektionszwecken, in Scheinwerfern oder Lichtstrahlern oder bei der Allgemeinbeleuchtung eingesetzt werden.

Nachfolgend wird ein hier beschriebener optoelektronischer Halbleiterchip sowie ein Verfahren zur Herstellung eines optoelektronischen Halbleiterchips unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Schnittdarstellung eines Ausführungsbeispiels eines hier beschriebenen optoelektronischen Halbleiterchips,
- Figuren 2 und 3: schematische Schnittdarstellungen weiterer Ausführungsbeispiele von hier beschriebenen Halbleiterchips,
- Figur 4: eine schematische Draufsicht auf eine Strahlungsdurchtrittsfläche eines weiteren Ausführungsbeispiels eines hier beschriebenen optoelektronischen Halbleiterchips,
- Figuren 5 und 6: schematische Schnittdarstellungen von weiteren Ausführungsbeispielen von hier beschriebenen optoelektronischen Halbleiterchips,
- Figur 7: schematische Draufsichten auf Auskoppelstrukturen und Strahlungsdurchtrittsflächen von hier beschriebenen optoelektronischen Halbleiterchips,
- Figuren 8 und 9: schematische Darstellungen der Abhängigkeit einer Auskoppeleffizienz von verschiedenen Parametern für hier beschriebene Halbleiterchips,
- Figur 10: eine schematische Seitenansicht einer domartigen hier beschriebenen Auskoppelstruktur,
- Figur 11: eine schematische Darstellung eines hier beschriebenen Verfahrens zur Herstellung eines hier beschriebenen optoelektronischen Halbleiterchips, und
- Figur 12: eine schematische Draufsicht (A) und eine schematische Schnittdarstellung (B) eines weiteren Ausführungsbeispiels eines hier beschriebenen optoelektronischen Halbleiterchips.

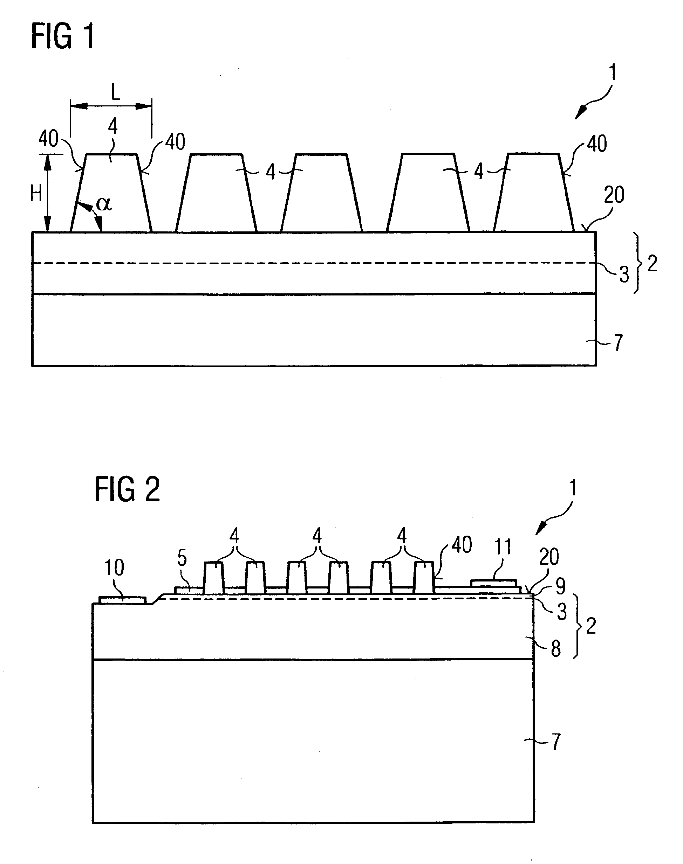

Ein Ausführungsbeispiel eines optoelektronischen Halbleiterchips 1 ist in Figur 1 gezeigt. Auf einem Substrat 7 befindet sich eine Halbleiterschichtenfolge 2. Die Halbleiterschichtenfolge 2 umfasst eine aktive Schicht 3, in der im Betrieb des Halbleiterchips 1 eine elektromagnetische Strahlung erzeugt wird. Beide Hauptseiten der Halbleiterschichtenfolge 2 sind im Rahmen der Herstellungstoleranzen glatt und sind nicht mit einer Aufrauung versehen. Auch das Substrat 7 weist glatte Hauptseiten auf.

Eine dem Substrat 7 abgewandte Seite der Halbleiterschichtenfolge 2 bildet eine Strahlungsdurchtrittsfläche 20, die durch ein Material der Halbleiterschichtenfolge 2 gebildet ist. Die Strahlungsdurchtrittsfläche 20 bildet eine dem Substrat 7 abgewandte, im Rahmen der Herstellungstoleranzen ebene Begrenzungsfläche der Halbleiterschichtenfolge 2.

An der Strahlungsdurchtrittsfläche 20 sind Auskoppelstrukturen 4 aufgebracht, die in direktem Kontakt zur Strahlungsdurchtrittsfläche 20 stehen. Ein Material der Auskoppelstrukturen 4 ist vom Material der Halbleiterschichtenfolge 2 verschieden. Eine Höhe H der Auskoppelstrukturen 4, in einer Richtung senkrecht zur Strahlungsdurchtrittsfläche 20, beträgt zirka 0,3 µm bis 4 µm. Eine laterale Ausdehnung L der Auskoppelstrukturen 4, in einer Richtung parallel zur Strahlungsdurchtrittsfläche 20, beträgt zirka 1 µm bis 7 µm. Die Auskoppelstrukturen 4 sind pyramidenstumpfartig oder, bevorzugt, kegelstumpfartig geformt. Eine Facette 40, die eine laterale Begrenzungsfläche der Auskoppelstrukturen 4 bildet, weist einen Winkel α zur Strahlungsdurchtrittsfläche 20 auf, der zwischen zirka 15° und 75°, beispielsweise um 60°, liegt. Eine Gesamtfläche der Facetten 40 beträgt mindestens 50 % eines Flächeninhalts der Strahlungsdurchtrittsfläche 20. Es ist ebenso möglich, dass die Gesamtfläche der Facetten 40 den Flächeninhalt der Strahlungsdurchtrittsfläche übersteigt.

Das Material der Auskoppelstrukturen 4 ist bezüglich der in der Halbleiterschichtenfolge 2 erzeugten Strahlung transparent. Zudem weist das Material der Auskoppelstrukturen 4 eine deutlich schlechtere elektrische Leitfähigkeit auf als das Material der Halbleiterschichtenfolge 2. Ein Brechungsindex der Materialien der Halbleiterschichtenfolge 2 beziehungsweise der Strahlungsdurchtrittsfläche 20 und der Auskoppelstrukturen 4 weicht um höchstens 5 % voneinander ab. Bei dem Substrat 7 kann es sich um ein Wachstumssubstrat handeln, auf dem die Halbleiterschichtenfolge 2 aufgewachsen ist. Ebenso ist es möglich, dass das Substrat 7 durch ein Trägersubstrat gebildet ist, auf dem die Halbleiterschichtenfolge 2 beispielsweise durch Umbonden oder durch einen Wafertransferprozess befestigt ist.

In Figur 2 ist ein weiteres Ausführungsbeispiel des optoelektronischen Halbleiterchips 1 illustriert. Auf dem Substrat 7, das mit Saphir gestaltet sein kann, ist eine n-leitende Schicht 8 aufgewachsen. Die wenigstens stellenweise n-leitende Schicht 8 basiert, wie die gesamte Halbleiterschichtenfolge 2 auch, auf GaN. An einer dem Substrat 7 abgewandten Seite der n-leitenden Schicht 8 ist die aktive Schicht 3 aufgewachsen, über der sich in einer Richtung vom Substrat 7 weg eine p-leitende Schicht 9 befindet. Eine Dicke der p-leitenden Schicht ist, in einer Richtung senkrecht zur Strahlungsdurchtrittsfläche 20, deutlich kleiner als eine Dicke der n-leitenden Schicht.

Auf der p-leitenden Schicht 9 ist zur Stromverteilung entlang der Strahlungsdurchtrittsfläche 20 eine leitende Schicht 5 aufgebracht. Die leitende Schicht 5 besteht zum Beispiel aus Indiumzinnoxid, Indiumzinkoxid oder Zinkoxid. Eine Dicke der leitenden Schicht 5, in einer Richtung senkrecht zur Strahlungsdurchtrittsfläche 20, beträgt hierbei 250 nm oder weniger. Die leitende Schicht 5 ist von den Auskoppelstrukturen 4 vollständig durchdrungen, so dass die Auskoppelstrukturen 4 in direktem Kontakt zur Strahlungsdurchtrittsfläche 20 stehen. Eine der Halbleiterschicht 2 abgewandte Seite der leitenden Schicht 5 ist im Rahmen der Herstellungstoleranzen glatt gestaltet. Ausnehmungen in der leitenden Schicht 5, in die die Auskoppelstrukturen 4 eingebracht sind, können durch einen Ätzprozess und/oder durch ein fotolithographisches Verfahren erzeugt sein. Die Strahlungsdurchtrittsfläche 20 ist eben gestaltet und die Auskoppelstrukturen 4 erheben sich über der Halbleiterschichtenfolge 2, in einer Richtung senkrecht zur Strahlungsdurchtrittsfläche 20. Es sind die Auskoppelstrukturen 4 also nicht durch eine Materialwegnahme aus der Halbleiterschichtenfolge 2 erzeugt.

Zur elektrischen Kontaktierung der Halbleiterschichtenfolge 2 ist auf der n-leitenden Schicht 8 ein n-Kontakt 10 aufgebracht. Auf der leitenden Schicht 5 befindet sich ein p-Kontakt 11. Die Kontakte 10, 11 sind zum Beispiel mit einem Metall gestaltet.

Eine alternative Möglichkeit zur Ausbildung der Auskoppelstrukturen 4 ist durch Ätzen der Halbleiterschichtenfolge 2 gegeben. Hierbei erfolgt das Erzeugen der Auskoppelstrukturen also durch Materialwegnahme insbesondere aus der n-leitenden 8 oder aus der p-leitenden Schicht 9. Um auf eine solche Art die Auskoppelstrukturen 4 erzeugen zu können, muss die n-leitende Schicht 8 oder die p-leitende Schicht 9 eine große Dicke aufweisen, um die für eine effiziente Auskoppelung erforderliche notwendige Höhe H der Auskoppelstrukturen erzeugen zu können.

Eine große Dicke der p- und n-leitenden Schichten 8, 9 kann zu Materialverspannungen in diesen Schichten 8, 9 führen, beispielsweise durch thermische Belastungen, so dass eine Lebensdauer des optoelektronischen Halbleiterchips 1 reduziert sein kann. Unter anderem deshalb ist eine möglichst geringe Dicke der Schichten 8, 9 bevorzugt. Dadurch, dass eine geringe Dicke der Schichten 8, 9 bevorzugt ist, ist das Erzeugen der Auskoppelstrukturen 4 durch Materialwegnahme aus der Halbleiterschichtenfolge 2 ein kritischer Prozess, da bei einer zu großen Materialwegnahme die aktive Schicht 3 beschädigt werden kann und der Halbleiterchip 1 dann nicht mehr verwendbar ist.

Durch das Aufbringen der Auskoppelstrukturen auf die Halbleiterschichtenfolge 2, ohne eine Materialwegnahme aus der Halbleiterschichtenfolge 2, entfällt also einerseits der kritische Prozess des Ätzens der leitenden Schichten 8, 9. Außerdem kann die Dicke der Schichten 8, 9 verkleinert sein und sich somit die Lebensdauer des optoelektronischen Halbleiterchips 1 erhöhen.

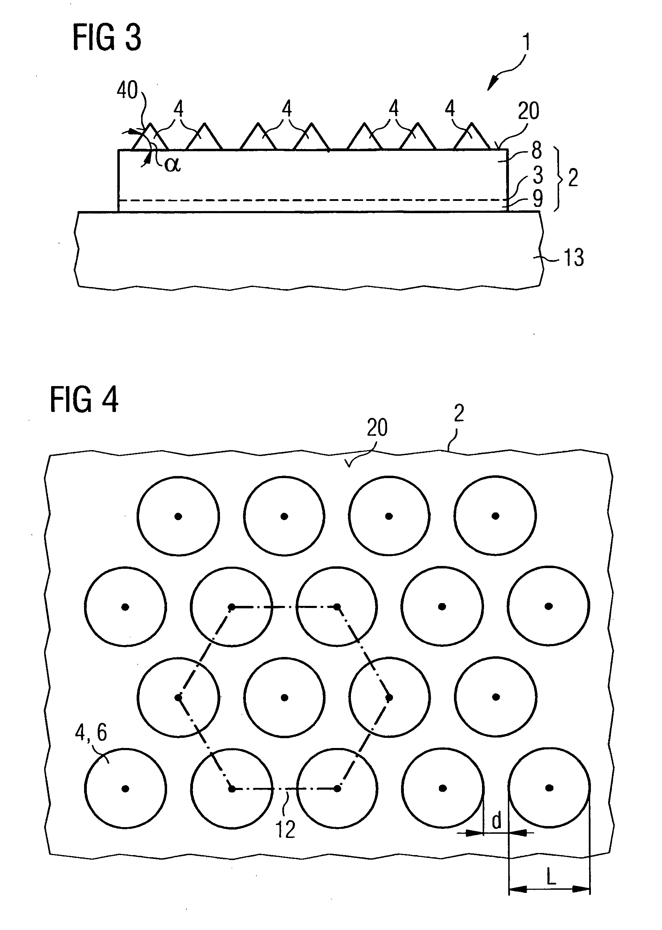

Beim Ausführungsbeispiel des Halbleiterchips 1 gemäß Figur 3 sind die Auskoppelstrukturen 4 kegelartig geformt. Der Winkel α zwischen den Facetten 40 und der Strahlungsdurchtrittsfläche 20 beträgt in etwa 45°.

Die Auskoppelstrukturen 4 sind auf der n-leitenden Schicht 8 aufgebracht. Die n-leitende Schicht 8 weist eine größere Querleitfähigkeit auf als die p-leitende Schicht 9.

Der Träger 13 ist durch ein Trägersubstrat gebildet, auf dem die Halbleiterschichtenfolge 2 nach Aufwachsen auf einem Wachstumssubstrat befestigt ist. Vor dem Erzeugen der Auskoppelstrukturen 4 wurde ein nicht gezeichnetes Wachstumssubstrat von der Halbleiterschichtenfolge 2 entfernt.

Optional kann der Halbleiterchip 1 einen nicht gezeichneten Vergusskörper aufweisen. Der Vergusskörper umgibt zum Beispiel die Halbleiterschichtenfolge 20 und die Auskoppelstrukturen 4.

In Figur 4 ist eine schematische Draufsicht auf einen Ausschnitt der Strahlungsdurchtrittsfläche 20 des Halbleiterchips 1, beispielsweise gemäß einer der Figuren 1 bis 3, gezeigt. Die Auskoppelstrukturen 4 bilden Inseln 6. Benachbarte Inseln 6 beziehungsweise Auskoppelstrukturen 4 sind voneinander separiert, das heißt durch das Material der Auskoppelstrukturen 4 oder der Inseln selbst ist keine Verbindung zwischen benachbarten Inseln 6 gegeben. Die Inseln 6 sind jeweils kegelartig geformt, so dass jeweils eine Insel 6 bevorzugt genau einer der Auskoppelstrukturen 4 entsprechen kann. Ein Abstand d zwischen benachbarten Inseln 6 ist größer als die Wellenlänge der in der Halbleiterschichtenfolge 2 erzeugten Strahlung.

Die Auskoppelstrukturen 4 sind über der gesamten Strahlungsdurchtrittsfläche 20 gleichmäßig in einem hexagonalen Muster angeordnet. Das hexagonale Muster ist geometrisch durch ein Gitter 12 beschreibbar, das, im Rahmen der Herstellungstoleranzen, durch identische, regelmäßige, gleichseitige Sechsecke gebildet ist. Der Anteil der von den Inseln 6 beziehungsweise von den Auskoppelstrukturen 4 bedeckten Fläche an der Strahlungsdurchtrittsfläche 20 beträgt zirka 50 %.

Alternativ ist es ebenso möglich, dass die Auskoppelstrukturen 4, anstelle des hexagonalen Gitters 12, etwa in einem quadratischen oder rechteckigen Gitter angeordnet sind. Anders als in den Figuren 1 bis 3 können die Inseln 6 oder die Auskoppelstrukturen 4 auch kuppelartige Formgebungen ähnlich zu den Segmenten von Kugeln oder Ellipsoiden aufweisen.

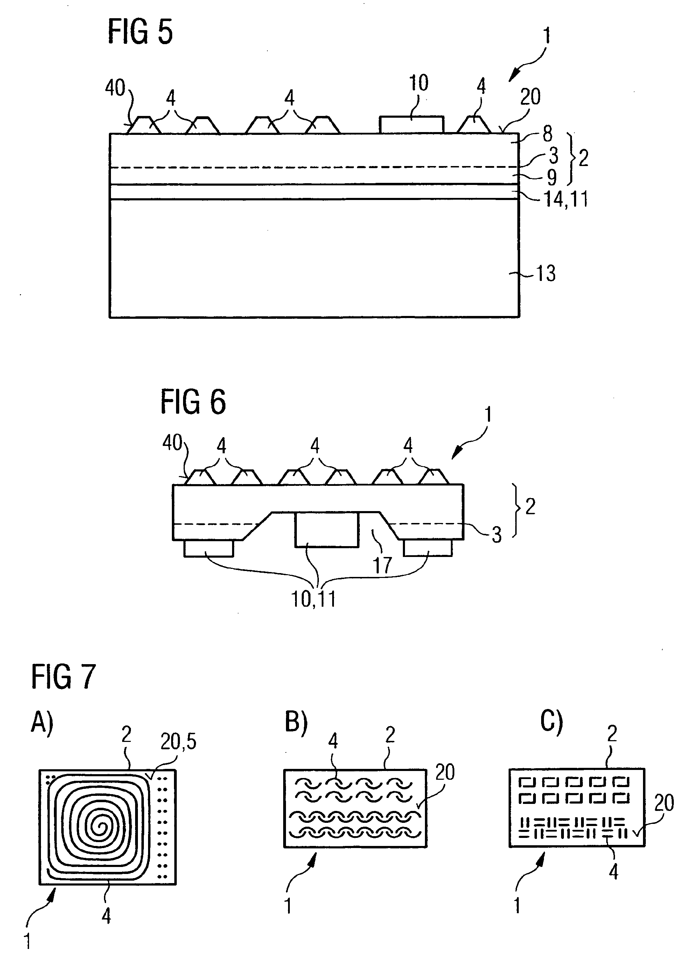

In Figur 5 ist ein Ausführungsbeispiel des optoelektronischen Halbleiterchips 1 dargestellt, bei dem die Halbleiterschichtenfolge 2 als Dünnfilmschicht gestaltet ist. Die Halbleiterschicht 2 ist über ein Verbindungsmittel 14 auf einem Träger 13 aufgebracht. Bei dem Träger 13 handelt es sich nicht um ein Substrat, auf dem die Halbleiterschichtenfolge 2 mit der aktiven Schicht 3 aufgewachsen wurde. Mit anderen Worten ist die Halbleiterschichtenfolge 2 auf einem nicht gezeichneten Aufwachssubstrat gewachsen und anschließend auf den Träger 13 umgebondet. Bei dem Verbindungsmittel 14 kann es sich um ein metallisches Lot handeln. Bevorzugt wirkt das Verbindungsmittel 14 reflektierend für die in der Halbleiterschichtenfolge 2 erzeugte Strahlung. Über das Verbindungsmittel 14 ist auch der p-Kontakt 11 realisiert.

Das Verbindungsmittel 14 kann auch durch ein Schichtsystem gebildet sein und beispielsweise ein oder mehrere Lote, wenigstens eine aufgedampfte Metalllage und mindestens eine reflektierende, insbesondere metallische Spiegelschicht umfassen.

Eine Dicke der p-leitenden Schicht 9, die dem Träger 13 zugewandt ist, beträgt in einer Richtung senkrecht zur Strahlungsdurchtrittsfläche 20 zirka 100 nm bis 2 µm. Die Dicke der n-leitenden Schicht 8, dem Träger 13 abgewandt, beträgt insbesondere zwischen einschließlich zirka 2 µm und 10 µm. Die gesamte Dicke der Halbleiterschichtenfolge 2, umfassend die n-leitende Schicht 8, die p-leitende Schicht 9 und die aktive Schicht 3, liegt bevorzugt im Bereich zwischen einschließlich 1 µm und 7 µm. Weder die p-leitende Schicht 9 noch die n-leitende Schicht 8 noch der Träger 13 sind mit einer Aufrauung versehen. Der Träger 13 weist bevorzugt eine Dicke zwischen einschließlich 100 µm und 200 µm auf. Eine Dicke des Verbindungsmittels 14 beträgt bevorzugt zwischen einschließlich 1 µm und 10 µm.

Unmittelbar auf der Strahlungsdurchtrittsfläche 20 der Halbleiterschichtenfolge 2 sind die Auskoppelstrukturen 4 in Form von Kegelstümpfen aufgebracht. Ebenfalls unmittelbar auf der Strahlungsdurchtrittsfläche 20 befindet sich der n-Kontakt 10. Der n-Kontakt 10 ist bevorzugt mit einem metallischen Material gestaltet oder besteht aus einem solchen.

Gemäß der Erfindung befindet sich, wie zum Beispiel beim Ausführungsbeispiel gemäß Figur 2, auf der Strahlungsdurchtrittsfläche 20 in Bereichen zwischen den Auskoppelstrukturen 4 eine in Figur 5 nicht gezeichnete Schicht mit einem elektrisch leitenden Material. Zusätzlich zu dieser leitenden Schicht kann das Material der Auskoppelstrukturen 4 elektrisch leitend sein.

Beim Ausführungsbeispiel gemäß Figur 6 weist die Halbleiterschichtenfolge 2 eine Ausnehmung 17 auf. Die Ausnehmung 17 durchdringt die aktive Schicht 3 stellenweise. In der Ausnehmung 17 ist einer der Kontakte 10, 11 angebracht. In diesem Ausführungsbeispiel des Halbleiterchips 1 befinden sich der n-Kontakt 10 und der p-Kontakt 11 an derselben Seite der Halbleiterschichtenfolge 2. Anders als in Figur 6 dargestellt ist es möglich, dass die Kontakte 10, 11 in einer Richtung von der Halbleiterschichtenfolge 2 weg miteinander bündig abschließen.

Bei den Ausführungsbeispielen des Halbleiterchips 1 gemäß den Figuren 1 bis 6 weisen die Auskoppelstrukturen 4 eine vergleichsweise einfache Geometrie auf. In Figur 7 sind Beispiele von Auskoppelstrukturen 4 illustriert, die eine komplexere Geometrie oder Strukturbebung aufweisen. In Figur 7 sind die Auskoppelstrukturen 4 vereinfacht jeweils als Striche dargestellt. Die Facetten 40 oder Umrisse der Auskoppelstrukturen 4 sind in Figur 7 also nicht gezeigt.

Gemäß Figur 7A ist die Auskoppelstruktur 4 durchgängig in einer einzigen Spirale auf der Strahlungsdurchtrittsfläche 20 der Halbleiterschichtenfolge 2 aufgebracht. Die Auskoppelstruktur 4 ist also durch einen zusammenhängenden, ununterbrochenen, lang gezogenen und spiralartig geformten Bereich gebildet. Ist auf der Strahlungsdurchtrittsfläche 20 in Bereichen zwischen der Auskoppelstruktur 4 eine leitende Schicht 5 aufgebracht, so wird diese leitende Schicht 5 durch die Auskoppelstruktur 4 nicht in voneinander elektrisch isolierte Teilareale unterbrochen. Mit anderen Worten ist auch diese optionale, leitende Schicht 5 durch einen durchgängigen, ununterbrochenen, flächigen Bereich gebildet.

Weiterhin können, neben etwa der spiralförmigen Auskoppelstruktur 4, insbesondere in Randbereichen der Strahlungsdurchtrittsfläche 20 weitere, zum Beispiel kegelstumpfartig geformte Auskoppelstrukturen 4 vorhanden sein.

Beim Ausführungsbeispiel der Auskoppelstrukturen 4 gemäß Figur 7B weisen die Auskoppelstrukturen 4 in Draufsicht eine bogenartige Formgebung auf. Verschiedene, bogenartige Auskoppelstrukturen 4 greifen jeweils zum Teil ineinander. Hierbei berühren sich benachbarte Auskoppelstrukturen 4 nicht. Durch eine solche Gestaltung der Auskoppelstrukturen 4 ist es möglich, dass die Auskoppelstrukturen 4 einen besonders hohen Flächenanteil der Strahlungsdurchtrittsfläche 20 bedecken.

In Figur 7C weisen die Auskoppelstrukturen 4 L-förmige und I-förmige Formgebungen auf. Insbesondere die Ausrichtung der I-förmigen Auskoppelstrukturen 4 ist alternierend, um eine hohe Auskoppeleffizienz zu erzielen. Zudem weist der Halbleiterchip 1 gemäß den Figuren 7B, 7C in Draufsicht jeweils einen rechteckigen, insbesondere nicht quadratischen Grundriss auf.

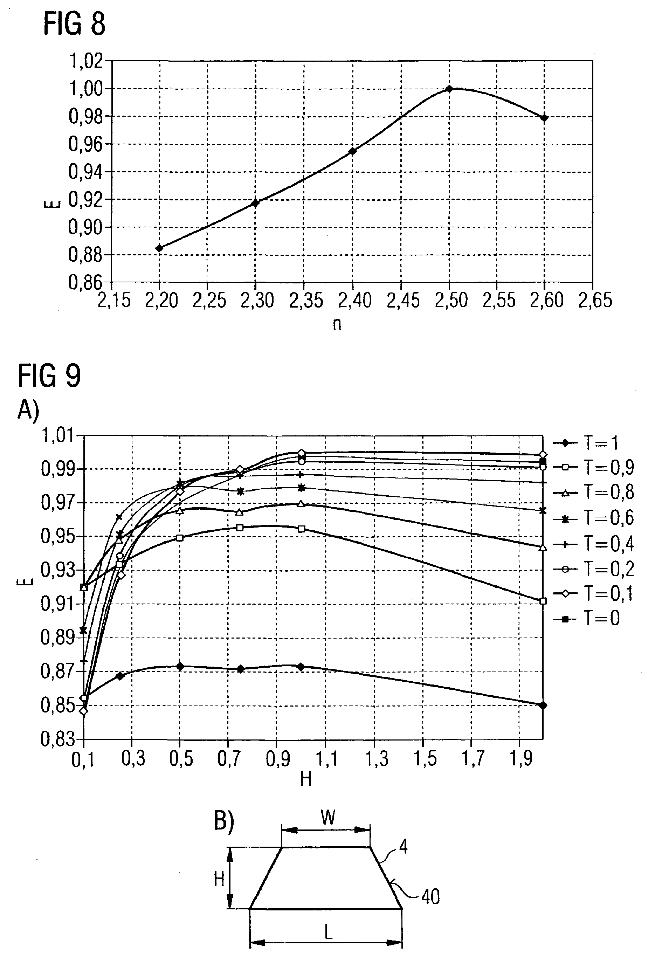

In Figur 8 ist der Verlauf der Auskoppeleffizienz E von in der Halbleiterschichtenfolge 2 erzeugter Strahlung aus dem Halbleiterchip 1 heraus in Abhängigkeit vom Brechungsindex n des Materials der Auskoppelstrukturen 4 illustriert. Ein Maximum der Auskoppeleffizienz E ist hierbei auf 1 skaliert. Die dargestellte Kurve bezieht sich auf eine Halbleiterschichtenfolge 2, die auf GaN basiert und einen Brechungsindex von zirka 2,5 aufweist. Ebenfalls sind die Halbleiterschichtenfolge 2 und die Auskoppelstrukturen 4 von einem Verguss aus einem Epoxid, einem Silikon oder einem Epoxid-Silikon-Hybridmaterial mit einem Brechungsindex von zirka 1,4 bis 1,5 umgeben.

Die Auskoppelstrukturen 4 bestehen aus TiO₂ und weisen eine pyramidenstumpfförmige Geometrie mit quadratischem Grundriss auf. Die Höhe H der Auskoppelstrukturen beträgt zirka 750 nm, die laterale Ausdehnung L etwa 1 µm und eine Breite W an einer Oberseite liegt bei zirka 0,5 µm, vergleiche auch Figur 9B.

Ist der Brechungsindex n der Auskoppelstrukturen 4 vergleichbar mit dem Brechungsindex der Halbleiterschichtenfolge 2, so ist die Auskoppeleffizienz E gemäß Figur 8 maximal. Dies ist im vorliegenden Fall bei einem Brechungsindex n der Auskoppelstrukturen 4 von zirka 2,5 der Fall. Dieser Brechungsindex entspricht näherungsweise dem von GaN. Mit einem von 2,5 abweichenden Brechungsindex n des Materials der Auskoppelstrukturen 4 nimmt die Auskoppeleffizienz E stark ab.

In Figur 9A ist eine Abhängigkeit der Auskoppeleffizienz E von der Höhe H und von einem Geometrieparameter T der Auskoppelstrukturen 4 dargestellt, für einen Halbleiterchip 1 analog zu Figur 8. Gemäß Figur 9A ist die Auskoppeleffizienz E dann am größten, wenn die Höhe H der in diesem Beispiel mit TiO₂ gestalteten Auskoppelstrukturen 4 zirka 750 nm beträgt oder übersteigt.

Je größer die Höhe H der Auskoppelstrukturen 4 ist, desto größer ist auch die Gesamtfläche der Facetten 40 der Auskoppelstrukturen 4. Da die Auskoppeleffizienz E mit der Gesamtfläche der Facetten 40 steigt, ist eine vergleichsweise große Höhe H der Auskoppelstrukturen 4 zu wählen. Da das Material der Auskoppelstrukturen 4, wie etwa TiO₂, eine kleine Restabsorption bezüglich der in der Halbleiterschichtenfolge 2 erzeugten Strahlung aufzeigt, führen zu große Höhen H der Auskoppelstrukturen 4 zu Absorptionsverlusten. Daher ist eine Höhe H der Auskoppelstrukturen 4 zwischen einschließlich zirka 0,5 µm und 2 µm bevorzugt.

Die Auskoppelstrukturen 4 aus Figur 9A weisen gemäß Figur 9B eine pyramidenstumpfartige Form mit einem quadratischen Grundriss auf. An der der Strahlungsdurchtrittsfläche 20 abgewandten Oberseite weisen die Auskoppelstrukturen 4 die Breite W auf. Der Geometrieparameter T ist definiert als der Quotient aus der Breite W und der lateralen Ausdehnung L der Auskoppelstrukturen 4. Es gilt also: T = W / L.

In Figur 9A ist zu sehen, dass mit abnehmendem Geometrieparameter T die Auskoppeleffizienz E zunimmt. Mit anderen Worten weisen solche Auskoppelstrukturen 4, bei denen die Facetten 40 nahezu senkrecht zur Strahlungsdurchtrittsfläche 20 orientiert sind, eine vergleichsweise geringe Auskoppeleffizienz E auf. Mit abnehmendem Geometrieparameter T erhöht sich die Gesamtfläche der Facetten 40, also der lateralen, bezüglich der Strahlungsdurchtrittsfläche 20 schräg orientierten Begrenzungsflächen der Auskoppelstrukturen 4, und damit einhergehend auch die Auskoppeleffizienz E.

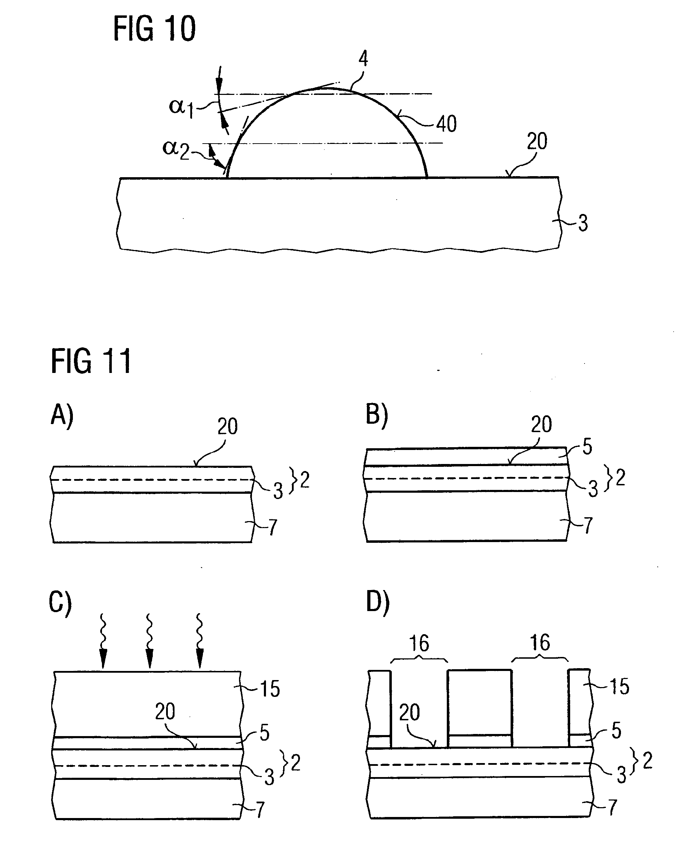

In Figur 10 ist eine domartige oder kugelsegmentartige Auskoppelstruktur 4 dargestellt. Die Auskoppelstruktur 4 weist eine einzige, durchgehende, der Strahlungsdurchtrittsfläche 20 abgewandte Begrenzungsfläche auf. Die Facette 40, die zu einer Steigerung der Auskoppeleffizienz E beiträgt, stellt insbesondere nur denjenigen Teil der Begrenzungsfläche dar, der einen Winkel zwischen einschließlich 15° und 75° bezüglich der Strahlungsdurchtrittsfläche 20 aufweist. Dieser, die Facette 40 bildende Teil der Begrenzungsfläche der Auskoppelstruktur 4 befindet sich in Figur 10 zwischen den beiden parallel zur Strahlungsdurchtrittsfläche 20 orientierten Strich-Punkt-Linien.

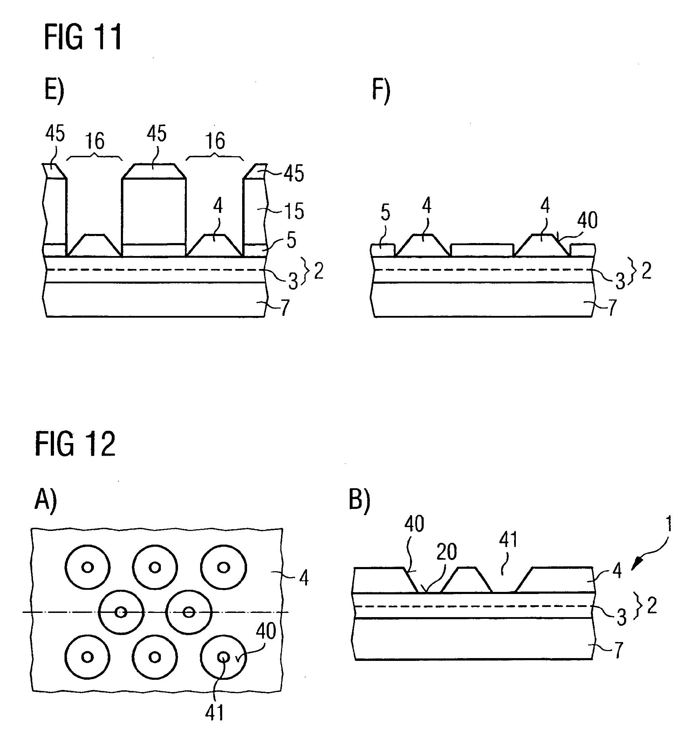

In Figur 11 ist ein Herstellungsverfahren für den optoelektronischen Halbleiterchip 1 illustriert. Gemäß Figur 11A ist die Halbleiterschichtenfolge 2 mit der aktiven Schicht 3 epitaktisch auf dem Substrat 7, das ein Wachstumssubstrat ist, aufgewachsen.

Im Verfahrensschritt gemäß Figur 11B wird auf der Strahlungsdurchtrittsfläche 20 der Halbleiterschichtenfolge 2 eine leitende Schicht 5 aufgebracht. Die leitende Schicht 5 besteht aus einem transparenten leitfähigen Oxid, beispielsweise aus ITO oder ZnO.

In Figur 11C ist dargestellt, dass auf der Strahlungsdurchtrittsfläche 20 oder auf der leitenden Schicht 5 eine Schicht eines lichtempfindlichen Materials 15 aufgebracht und strukturiert wird. Beispielsweise ist das lichtempfindliche Material 15 ein Fotolack, der mit einer Dicke aufgebracht wird, die bevorzugt größer ist als die Höhe H der zu erzeugenden Auskoppelstrukturen 4. Die Strukturierung des lichtempfindlichen Materials erfolgt zum Beispiel durch Belichten mit Hilfe einer in Figur 11 nicht gezeichneten Fotomaske. Nachfolgend kann das lichtempfindliche Material 15 gegebenenfalls entwickelt werden.

In Figur 11D ist dargestellt, dass in Teilbereichen 16 das lichtempfindliche Material 15 und die leitende Schicht 5 entfernt werden. Insbesondere wird in den Teilbereichen 16 die Strahlungsdurchtrittsfläche 20 der Halbleiterschichtenfolge 2 freigelegt.

Gemäß Figur 11E werden in den Teilbereichen 16 die Auskoppelstrukturen 40 erzeugt. Es ist möglich, dass ein Material 45 der Auskoppelstrukturen 4 auch auf dem lichtempfindlichen Material 15 außerhalb der Teilbereiche 16 abgeschieden wird.

Gemäß Figur 11F wird das restliche, im Verfahrensschritt gemäß Figur 11D nicht entfernte lichtempfindliche Material 15 entfernt. Mit diesem Entfernen wird auch eventuell auf dem lichtempfindlichen Material 15 unerwünschtes, abgeschiedenes Material 45 entfernt. Das Entfernen des restlichen lichtempfindlichen Materials 15 kann durch ein Abblasen erfolgen.

Beim Ausführungsbeispiel des optoelektronischen Halbleiterchips 1 gemäß Figur 12 weisen die Auskoppelstrukturen 4 eine Mehrzahl von Öffnungen 41 auf. Das Material der Auskoppelstrukturen 4 ist hierbei in einer durchgehenden Schicht auf der Strahlungsdurchtrittsfläche 20 aufgebracht. Durch die Öffnungen 41, die diese Schicht vollständig durchdringen und bis zur Strahlungsdurchtrittsfläche 20 reichen, sind dann die Facetten 40 der Auskoppelstrukturen 4 gebildet. Die Öffnungen 41 weisen zum Beispiel eine kegelstumpfähnliche Form auf, wobei sich die Öffnungen 41 zur Strahlungsdurchtrittsfläche 20 hin verjüngen.

Anders als in Figur 12 dargestellt, können mehrere, voneinander getrennte schichtartige Bereiche des Materials der Auskoppelstrukturen 4 an der Strahlungsdurchtrittsfläche 20 aufgebracht sein, die jeweils eine Mehrzahl von Öffnungen 41 aufweisen. Gemäß der Erfindung befindet sich zwischen den Auskoppelstrukturen 4 und der Halbleiterschichtenfolge 2 eine nicht gezeichnete, leitende Schicht 5, zum Beispiel analog zum Halbleiterchip 1 gemäß Figur 2. Es ist möglich, dass die Öffnungen 41 diese leitende Schicht 5 nicht durchdringen.

Die hier beschriebene Erfindung ist nicht durch die Beschreibung anhand der Ausführungsbeispiele beschränkt.

Diese Patentanmeldung beansprucht die Priorität der deutschen Patentanmeldung 10 2008 062 932.4.

## Patentansprüche

1. Optoelektronischer Halbleiterchip (1) mit einer Halbleiterschichtenfolge (2) mit mindestens einer aktiven Schicht (3) zur Erzeugung einer elektromagnetischen Strahlung und mit Auskoppelstrukturen (4), die mindestens mittelbar auf einer Strahlungsdurchtrittsfläche (20) der Halbleiterschichtenfolge (2) aufgebracht sind, wobei
- ein Material der Auskoppelstrukturen (4) von einem Material der Halbleiterschichtenfolge (2) verschieden ist,
- die Brechungsindices der Materialien der Auskoppelstrukturen (4) und der Halbleiterschichtenfolge (2) um höchstens 30 % voneinander abweichen,
- Facetten (40) der Auskoppelstrukturen (4) eine Gesamtfläche aufweisen, die mindestens 5 % eines Flächeninhalts der Strahlungsdurchtrittsfläche (20) beträgt, und
- die Auskoppelstrukturen (4) unmittelbar auf der Strahlungsdurchtrittsfläche angebracht sind, und
- durch das Material der Auskoppelstrukturen (4) mehrere Inseln (6) gebildet sind, wobei benachbarte Inseln (6) voneinander separiert sind und zwischen benachbarten Inseln keine Verbindung durch das Material der Auskoppelstrukturen selbst besteht, **dadurch gekennzeichnet, dass**
- auf der Strahlungsdurchtrittsfläche (20) der Halbleiterschichtenfolge (2) wenigstens eine elektrisch leitende Schicht (5) aufgebracht ist, wobei die leitende Schicht (5) mit einem transparenten, leitfähigen Oxid gestaltet ist und die Auskoppelstrukturen (4) die leitende Schicht (5) vollständig durchdringen.

2. Optoelektronischer Halbleiterchip (1) nach Anspruch 1, bei dem die Facetten (40) solche Begrenzungsflächen oder Teile der Begrenzungsflächen der Auskoppelstrukturen (4) sind, die einen Winkel (α) von mindestens 15° und von höchstens 75° mit der Strahlungsdurchtrittsfläche (20) einschließen.

3. Optoelektronischer Halbleiterchip (1) nach einem der vorhergehenden Ansprüche,
bei dem die Auskoppelstrukturen (4) in einer Richtung parallel zur Strahlungsdurchtrittsfläche (20) eine laterale Ausdehnung (L) aufweisen, die zwischen einschließlich 0,2 µm und 10 µm liegt, und bei dem die Auskoppelstrukturen (4) in einer Richtung senkrecht zur Strahlungsdurchtrittsfläche (20) eine Höhe (H) aufweisen, die zwischen einschließlich 0,3 µm und 10 µm liegt.

4. Optoelektronischer Halbleiterchip (1) nach dem vorhergehenden Anspruch,
wobei Hauptseiten der Halbleiterschichtenfolge (2) und die leitende Schicht (5) glatt sind und nicht aufgeraut.

5. Optoelektronischer Halbleiterchip (1) nach einem der vorhergehenden Ansprüche,
bei dem die Auskoppelstrukturen (4) pyramidenstumpfartig, kugelsegmentartig, kuppelartig und/oder kegelstumpfartig gestaltet sind, wobei eine Basisfläche der Auskoppelstrukturen (4) der Strahlungsdurchtrittsfläche (20) zugewandt ist.

6. Optoelektronischer Halbleiterchip (1) nach einem der vorhergehenden Ansprüche,
bei dem eine Dicke der leitenden Schicht (5), in einer Richtung senkrecht zur Strahlungsdurchtrittsfläche (20), 250 nm oder weniger beträgt.

7. Optoelektronischer Halbleiterchip (1) nach einem der vorhergehenden Ansprüche,
bei dem die Inseln (6) jeweils durch genau ein Strukturelement der Auskoppelstrukturen (4) gebildet sind.

8. Optoelektronischer Halbleiterchip (1) nach einem der vorhergehenden Ansprüche,
bei dem das Material der Auskoppelstrukturen (4) einen der folgenden Stoffe enthält oder hieraus besteht: TiO₂, ZnS, AlN, SiC, BN, Ta₂O₅.

9. Optoelektronischer Halbleiterchip (1) nach einem der vorhergehenden Ansprüche,
bei dem die Gesamtfläche der Facetten (40) der Auskoppelstrukturen (4) mindestens 20 % des Flächeninhalts der Strahlungsdurchtrittsfläche (20) beträgt.

10. Optoelektronischer Halbleiterchip (1) nach einem der vorhergehenden Ansprüche,
bei dem das Material der Auskoppelstrukturen (4) einen Brechungsindex zwischen einschließlich 2,4 und 2,6 aufweist.

11. Optoelektronischer Halbleiterchip (1) nach einem der vorhergehenden Ansprüche,
bei dem
- das Material der Halbleiterschichtenfolge (2) auf GaN, InGaN, AlGaN und/oder AlInGaN basiert,
- der Winkel (α) zwischen der Strahlungsdurchtrittsfläche (20) und den Facetten (40) der Auskoppelstrukturen (4) zwischen einschließlich 30° und 60° liegt, und
- die Auskoppelstrukturen (4) kegelstumpfartig geformt sind und aus TiO₂ bestehen.

12. Verfahren zur Herstellung eines optoelektronischen Halbleiterchips mit den Schritten:
- Wachsen einer Halbleiterschichtenfolge (2) mit mindestens einer aktiven Schicht (3) auf einem Substrat (7),
- Aufbringen und Strukturieren eines lichtempfindlichen Materials (15) an einer Strahlungsdurchtrittsfläche (20) der Halbleiterschichtenfolge (2),
- Entfernen des lichtempfindlichen Materials (15) in Teilbereichen (16),
- Erstellen von Auskoppelstrukturen (4) mindestens mittelbar an der Strahlungsdurchtrittsfläche (20) in den Teilbereichen (16), und
- Entfernen des restlichen lichtempfindlichen Materials (15),
wobei ein Material der Auskoppelstrukturen (4) von einem Material der Halbleiterschichtenfolge (2) verschieden ist und die Materialien sich im Brechungsindex um höchstens 30 % voneinander unterscheiden,
und wobei eine Gesamtfläche von Facetten der Auskoppelstrukturen (4) mindestens 5 % eines Flächeninhalts der Strahlungsdurchtrittsfläche (20) beträgt,
die Auskoppelstrukturen (4) unmittelbar auf der Strahlungsdurchtrittsfläche angebracht werden, und
- durch das Material der Auskoppelstrukturen (4) mehrere Inseln (6) gebildet werden, wobei benachbarte Inseln (6) voneinander separiert sind und zwischen benachbarten Inseln keine Verbindung durch das Material der Auskoppelstrukturen selbst besteht, **dadurch gekennzeichnet, dass**
- auf der Strahlungsdurchtrittsfläche (20) der Halbleiterschichtenfolge (2) wenigstens eine elektrisch leitende Schicht (5) aufgebracht wird, wobei die leitende Schicht (5) aus einem transparenten, leitfähigen Oxid gestaltet wird und die Auskoppelstrukturen (4) die leitende Schicht (5) vollständig durchdringen.

13. Verfahren nach Anspruch 12, wobei vor dem Aufbringen und Strukturieren des lichtempfindlichen Materials (15) zwischen diesem und der Strahlungsdurchtrittsfläche (20) wenigstens stellenweise die leitende Schicht (5) erzeugt wird, und wobei mit dem Entfernen des lichtempfindlichen Materials (15) in den Teilbereichen (16) die leitende Schicht (5) in diesen Teilbereichen (16) teilweise entfernt wird.

14. Verfahren nach Anspruch 12 oder 13,
wobei ein optoelektronischer Hableiterchip (1) gemäß einem der Ansprüche 1 bis 11 hergestellt wird.

## Claims

1. Optoelectronic semiconductor chip (1) comprising a semiconductor layer sequence (2) comprising at least one active layer (3) for generating an electromagnetic radiation and comprising coupling-out structures (4), which are applied at least indirectly on a radiation passage area (20) of the semiconductor layer sequence (2),
wherein
- a material of the coupling-out structures (4) is different than a material of the semiconductor layer sequence (2),
- the refractive indices of the materials of the coupling-out structures (4) and of the semiconductor layer sequence (2) deviate from one another by at most 30%,
- facets (40) of the coupling-out structures (4) have a total area amounting to at least 5% of an area content of the radiation passage area (20), and
- the coupling-out structures (4) are fitted directly on the radiation passage area, and
- a plurality of islands (6) are formed by the material of the coupling-out structures (4), wherein adjacent islands (6) are separated from one another and there is no connection by the material of the coupling-out structures themselves between adjacent islands, **characterized in that**
- at least one electrically conductive layer (5) is applied on the radiation passage area (20) of the semiconductor layer sequence (2), wherein the conductive layer (5) is fashioned with a transparent conductive oxide, and the coupling-out structures (4) completely penetrate through the conductive layer (5).

2. Optoelectronic semiconductor chip (1) according to Claim 1,
wherein the facets (40) are those boundary areas or parts of the boundary areas of the coupling-out structures (4) which form an angle (α) of at least 15° and of at most 75° with the radiation passage area (20).

3. Optoelectronic semiconductor chip (1) according to either of the preceding claims,
wherein the coupling-out structures (4) have a lateral extent (L) of between 0.2 µm and 10 µm inclusive in a direction parallel to the radiation passage area (20), and wherein the coupling-out structures (4) have a height (H) of between 0.3 µm and 10 µm inclusive in a direction perpendicular to the radiation passage area (20).

4. Optoelectronic semiconductor chip (1) according to the preceding claim,
wherein main sides of the semiconductor layer sequence (2) and the conductive layer (5) are smooth and not roughened.

5. Optoelectronic semiconductor chip (1) according to any of the preceding claims,
wherein the coupling-out structures (4) are fashioned in truncated-pyramid-like fashion, in sphere-segment-like fashion, in dome-like fashion and/or in truncated-cone-like fashion, wherein a base area of the coupling-out structures (4) faces the radiation passage area (20).

6. Optoelectronic semiconductor chip (1) according to any of the preceding claims,
wherein a thickness of the conductive layer (5), in a direction perpendicular to the radiation passage area (20), is 250 nm or less.

7. Optoelectronic semiconductor chip (1) according to any of the preceding claims,
wherein the islands (6) are in each case formed by precisely one structure element of the coupling-out structures (4).

8. Optoelectronic semiconductor chip (1) according to any of the preceding claims,
wherein the material of the coupling-out structures (4) contains or consists of one of the following substances: TiO₂, ZnS, AlN, SiC, BN, Ta₂O₅.

9. Optoelectronic semiconductor chip (1) according to any of the preceding claims,
wherein the total area of the facets (40) of the coupling-out structures (4) amounts to at least 20% of the area content of the radiation passage area (20).

10. Optoelectronic semiconductor chip (1) according to any of the preceding claims,
wherein the material of the coupling-out structures (4) has a refractive index of between 2.4 and 2.6 inclusive.

11. Optoelectronic semiconductor chip (1) according to any of the preceding claims,
wherein
- the material of the semiconductor layer sequence (2) is based on GaN, InGaN, AlGaN and/or AlInGaN,
- the angle (α) between the radiation passage area (20) and the facets (40) of the coupling-out structures (4) is between 30° and 60° inclusive, and
- the coupling-out structures (4) are shaped in truncated-cone-like fashion and consist of TiO₂.

12. Method for producing an optoelectronic semiconductor chip comprising the following steps:
- growing a semiconductor layer sequence (2) comprising at least one active layer (3) on a substrate (7),
- applying and patterning a light-sensitive material (15) at a radiation passage area (20) of the semiconductor layer sequence (2),
- removing the light-sensitive material (15) in partial regions (16),
- producing coupling-out structures (4) at least indirectly at the radiation passage area (20) in the partial regions (16), and
- removing the remaining light-sensitive material (15),
wherein a material of the coupling-out structures (4) is different than a material of the semiconductor layer sequence (2) and the materials differ from one another in terms of the refractive index by at most 30%,
and wherein a total area of facets of the coupling-out structures (4) amounts to at least 5% of an area content of the radiation passage area (20),
- the coupling-out structures (4) are fitted directly on the radiation passage area, and
- a plurality of islands (6) are formed by the material of the coupling-out structures (4), wherein adjacent islands (6) are separated from one another and there is no connection by the material of the coupling-out structures themselves between adjacent islands, **characterized in that**
- at least one electrically conductive layer (5) is applied on the radiation passage area (20) of the semiconductor layer sequence (2), wherein the conductive layer (5) is fashioned with a transparent conductive oxide, and the coupling-out structures (4) completely penetrate through the conductive layer (5).

13. Method according to Claim 12,
wherein, prior to applying and patterning the light-sensitive material (15), the conductive layer (5) is produced at least in places between said material and the radiation passage area (20),
and wherein, with the removal of the light-sensitive material (15) in the partial regions (16), the conductive layer (5) is partly removed in said partial regions (16).

14. Method according to Claim 12 or 13,
wherein an optoelectronic semiconductor chip (1) according to any of Claims 1 to 11 is produced.

## Revendications

1. Puce semiconductrice optoélectronique (1) comprenant une suite de couches semiconductrices (2) avec au moins une couche active (3) pour générer un rayonnement électromagnétique et comprenant des structures de découplage (4) qui sont appliquées au moins indirectement sur une surface de traversée de rayonnement (20) de la suite de couches semiconductrices (2), avec laquelle
- un matériau des structures de découplage (4) est différent d'un matériau de la suite de couches semiconductrices (2),
- l'indice de réfraction des matériaux des structures de découplage (4) et de la suite de couches semiconductrices (2) diffèrent l'un de l'autre au maximum de 30 %,
- les facettes (40) des structures de découplage (4) présentent une surface totale qui est égale à au moins 5 % d'une superficie de la surface de traversée de rayonnement (20), et
- les structures de découplage (4) sont appliquées directement sur la surface de traversée de rayonnement, et
- plusieurs îlots (6) sont formés par le matériau des structures de découplage (4), les îlots (6) voisins étant séparés les uns des autres et il n'existe entre les îlots voisins aucune liaison par le matériau des structures de découplage lui-même,
**caractérisée en ce que**
- au moins une couche électriquement conductrice (5) est appliquée sur la surface de traversée de rayonnement (20) de la suite de couches semiconductrices (2), la couche conductrice (5) étant façonnée avec un oxyde transparent conducteur et les structures de découplage (4) traversant complètement la couche conductrice (5).

2. Puce semiconductrice optoélectronique (1) selon la revendication 1, avec laquelle les facettes (40) sont des surfaces de délimitation ou des parties des surfaces de délimitation des structures de découplage (4) telles qu'elles forment un angle (α) de minimum 15° et de maximum 75° avec la surface de traversée de rayonnement (20).

3. Puce semiconductrice optoélectronique (1) selon l'une des revendications précédentes, avec laquelle les structures de découplage (4) présentent dans une direction parallèle à la surface de traversée de rayonnement (20) une expansion latérale (L) qui est comprise entre 0,2 µm et 10 µm inclus et avec laquelle les structures de découplage (4) présentent dans une direction perpendiculaire à la surface de traversée de rayonnement (20) une hauteur (H) qui est comprise entre 0,3 µm et 10 µm inclus.

4. Puce semiconductrice optoélectronique (1) selon la revendication précédente, avec laquelle les côtés principaux de la suite de couches semiconductrices (2) et la couche conductrice (5) sont lisses et non rugueux.

5. Puce semiconductrice optoélectronique (1) selon l'une des revendications précédentes, avec laquelle les structures de découplage (4) sont façonnées à la manière de pyramides tronquées, de segments de sphère, de coupoles et/ou de cônes tronqués, une surface de base des structures de découplage (4) faisant face à la surface de traversée de rayonnement (20).

6. Puce semiconductrice optoélectronique (1) selon l'une des revendications précédentes, avec laquelle une épaisseur de la couche conductrice (5), dans une direction perpendiculaire à la surface de traversée de rayonnement (20), est égale à 250 nm ou moins.

7. Puce semiconductrice optoélectronique (1) selon l'une des revendications précédentes, avec laquelle les îlots (6) sont respectivement formés par exactement un élément structurel des structures de découplage (4).

8. Puce semiconductrice optoélectronique (1) selon l'une des revendications précédentes, avec laquelle le matériau des structures de découplage (4) contient l'une des substances suivantes ou en est composé : TiO₂, ZnS, AlN, SiC, BN, Ta₂O₅.

9. Puce semiconductrice optoélectronique (1) selon l'une des revendications précédentes, avec laquelle la surface totale des facettes (40) des structures de découplage (4) est égale à au moins 20 % de la superficie de la surface de traversée de rayonnement (20).

10. Puce semiconductrice optoélectronique (1) selon l'une des revendications précédentes, avec laquelle le matériau des structures de découplage (4) présente un indice de réfraction compris entre 2,4 et 2,6 inclus.

11. Puce semiconductrice optoélectronique (1) selon l'une des revendications précédentes, avec laquelle
- le matériau de la suite de couches semiconductrices (2) est à base de GaN, InGaN, AlGaN et/ou AlInGaN,
- l'angle (α) entre la surface de traversée de rayonnement (20) et les facettes (40) des structures de découplage (4) est compris entre 30° et 60° inclus, et
- les structures de découplage (4) sont formées à la manière des cônes tronqués et se composent de TiO₂.

12. Procédé de fabrication d'une puce semiconductrice optoélectronique comprenant les étapes suivantes :
- croissance d'une suite de couches semiconductrices (2) avec au moins une couche active (3) sur un substrat (7),
- application et structuration d'un matériau photosensible (15) sur une surface de traversée de rayonnement (20) de la suite de couches semiconductrices (2),
- enlèvement du matériau photosensible (15) dans des zones partielles (16),
- création de structures de découplage (4) au moins indirectement sur la surface de traversée de rayonnement (20) dans les zones partielles (16), et
- enlèvement du reste du matériau photosensible (15),
selon lequel un matériau des structures de découplage (4) est différent d'un matériau de la suite de couches semiconductrices (2) et les matériaux se différencient l'un de l'autre au maximum de 30 % par leur indice de réfraction,
et une surface totale des facettes des structures de découplage (4) est égale à au moins 5 % d'une superficie de la surface de traversée de rayonnement (20),
les structures de découplage (4) sont appliquées directement sur la surface de traversée de rayonnement, et
- plusieurs îlots (6) sont formés par le matériau des structures de découplage (4), les îlots (6) voisins étant séparés les uns des autres et il n'existe entre les îlots voisins aucune liaison par le matériau des structures de découplage lui-même,
**caractérisé en ce que**
- au moins une couche électriquement conductrice (5) est appliquée sur la surface de traversée de rayonnement (20) de la suite de couches semiconductrices (2), la couche conductrice (5) étant façonnée en un oxyde transparent conducteur et les structures de découplage (4) traversant complètement la couche conductrice (5).

13. Procédé selon la revendication 12, selon lequel la couche conductrice (5) est produite au moins par endroits avant l'application et la structuration du matériau photosensible (15) ente celui-ci et la surface de traversée de rayonnement (20), et selon lequel la couche conductrice (5) est partiellement enlevée dans les zones partielles (16) avec l'enlèvement du matériau photosensible (15) dans ces zones partielles (16).

14. Procédé selon la revendication 12 ou 13, selon lequel est fabriqué une puce semiconductrice optoélectronique (1) selon l'une des revendications 1 à 11.
